(19) Europäisches Patentamt
European Patent Office
Office européen des brevets

(11) **EP 2 283 553 B1**

(12) **FASCICULE DE BREVET EUROPEEN**

(45) Date de publication et mention
de la délivrance du brevet:
**02.11.2011 Bulletin 2011/44**

(21) Numéro de dépôt: **09745838.4**

(22) Date de dépôt: **15.05.2009**

(51) Int Cl.:
*H02B 13/00* *(2006.01)* *G01K 11/26* *(2006.01)*
*H03H 9/02* *(2006.01)*

(86) Numéro de dépôt international:
**PCT/EP2009/055952**

(87) Numéro de publication internationale:
**WO 2009/138506 (19.11.2009 Gazette 2009/47)**

(54) **MESURE DE TEMPERATURE A L'INTERIEUR D'ENVELOPPES DE MATERIELS ELECTRIQUES SOUS TENSION.**

MESSEN DER TEMPERATUR IN GEHÄUSEN VON MIT STROM VERSORGTEN ELEKTRISCHEN GERÄTEN

MEASURING THE TEMPERATURE INSIDE HOUSINGS OF POWERED ELECTRIC EQUIPMENT

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **16.05.2008 FR 0853184**

(43) Date de publication de la demande:
**16.02.2011 Bulletin 2011/07**

(73) Titulaire: **AREVA T&D SAS**
**92084 Paris La Défense Cedex (FR)**

(72) Inventeurs:
• **JUGE, Patrice**
**F-74150 Marcellaz Albanais (FR)**

• **FOURNET, Claude**
**F-73100 Aix-les-bains (FR)**

(74) Mandataire: **Ilgart, Jean-Christophe et al**
**BREVALEX**
**95 rue d'Amsterdam**
**75378 Paris Cedex 8 (FR)**

(56) Documents cités:
**WO-A1-99/48200 US-A- 5 739 419**
**US-A- 6 111 548 US-A1- 2002 150 141**
**US-A1- 2007 064 765**

## Description

L'invention porte sur la mesure de température à l'intérieur d'enveloppes de matériels électriques sous tension.

De telles mesures sont utiles à la sécurité ou au suivi du bon fonctionnement des matériels. Les matériels de type PSEM (Portes sous Enveloppe Mécanique) sont constitués d'une enveloppe métallique externe et d'un ou plusieurs conducteurs primaires internes maintenus mécaniquement par des isolateurs assurant également la tenue diélectrique.

Les contraintes d'exploitation des réseaux de transport et distribution d'électricité nécessitent de plus en plus la maîtrise des charges et des surcharges temporaires et de leurs effets sur les équipements. Comme les autres équipements des réseaux, les postes PSEM sont de plus en plus utilisés et chargés en courant alors que leur volume tend par ailleurs à diminuer pour les nouvelles générations de matériels. Les charges permanentes de courant transitant sont de plus en plus souvent proches des valeurs nominales de l'équipement PSEM. Les surcharges peuvent conduire à les dépasser temporairement, ce que peut accepter le PSEM dans certaines limites. Il devient donc utile de disposer de moyens de mesure adaptés afin d'informer l'exploitant sur la marge d'exploitation disponible.

Il se trouve que les isolateurs constituent de ce point de vue un organe critique.

La matière des isolateurs, le plus souvent constituée de résine époxy et d'alumine, présente la particularité de présenter un seuil de température haut à ne pas dépasser, au risque de franchir le seuil de transition vitreuse de la matière. Les conséquences sur la matière du franchissement de ce seuil conduisent à une perte irréversible des caractéristiques diélectriques et mécaniques initiales. L'arrêt du PSEM est alors nécessaire pour maintenance lourde.

Le seuil de transition vitreuse est relativement bas, de l'ordre d'une centaine de degrés, or la matière des isolateurs conduit très peu la chaleur.

Les conducteurs des PSEM, formés des barres et des porte-contacts fixes et mobiles, présentent des résistances non nulles. Les isolateurs maintiennent dans leur partie centrale les porte-contacts des barres, les contacts des barres étant à proximité immédiate. En cas de fort courant, la chaleur générée dans les contacts des barres et dans les barres est conduite dans tout le conducteur primaire. En cas de dégradation de la qualité d'un contact, la chaleur libérée peut être importante. Cette chaleur est alors dirigée en particulier vers les isolateurs, exposés ainsi à une dégradation.

Les isolateurs qui sont au contact du conducteur primaire sont donc exposés à des contraintes thermiques importantes entre l'intérieur au contact du conducteur primaire, et l'extérieur au contact des enveloppes externes et de l'air ambiant. Plus particulièrement, il convient de veiller à ne pas atteindre le seuil de transition vitreuse à l'endroit du contact avec le porte-contacts de barre, qui est le point le plus chaud. Cela implique une mesure de la température. Une surveillance de ce type permet de réguler la charge électrique qui transite dans l'équipement primaire en fonction de son échauffement, et d'optimiser l'exploitation, en tolérant éventuellement des surcharges temporaires de 5, 10 ou 20 min qui n'attenteraient pas à la continuité d'exploitation ni à la durée de vie de l'équipement.

Comme les isolateurs conduisent peu la chaleur, une mesure de température depuis la face externe de l'isolateur n'est pas exploitable en raison du manque de précision de la mesure et du retard excessif au diagnostic d'un échauffement. De même, une mesure de température à partir d'une sonde noyée dans la matière de l'isolateur n'apporte pas l'efficacité souhaitée. De plus, un tel concept pose des problèmes de fabrication lors de la phase de moulage de l'isolateur, dont les propriétés diélectriques peuvent aussi être affectées par exemple par la présence de bulles d'air prisonnières.

Une mesure localisée dans la zone de maintien du porte-contacts, au point le plus chaud, est nécessaire mais reste difficile compte tenu des contraintes diélectriques (l'isolement entre le conducteur primaire et l'enveloppe externe doit être maintenu) et particulièrement difficiles à cet endroit : le capteur doit tenir à la température, aux champs électriques et magnétiques, aux gaz ambiants, etc.

Par extension, cette mesure de température à ce point précis peut être exploitée afin de détecter une éventuelle dégradation des contacts d'un sectionneur constitué de pièces mobiles, ces contacts étant proches.

Les matériels électriques envisagés ici sont en général ceux qui possèdent une partie active sous tension entourée par une enveloppe de protection, parmi lesquels on peut citer les matériels de type GIS (Gas insulated switchgear) ou PSEM (Poste sous enveloppe mécanique), ou les câbles de transport de courant à haute tension. Ces mesures à l'intérieur de l'enveloppe sont délicates en raison des courants électriques qui parcourent les parties actives. L'intrusion de la mesure oblige à traverser l'enveloppe pour accéder à l'intérieur du matériel.

On a déjà employé des fibres optiques pour mesurer des températures dans de tels matériels, ou encore des faisceaux laser ou infrarouges. De telles techniques sont coûteuses en raison de la nécessité de modifier les matériels en créant des points de traversée de l'enveloppe pour les fibres ou des hublots pour les faisceaux. Il faut aussi souligner que ces ouvertures de l'enveloppe sont susceptibles de réduire la durée de vie du matériel en l'affaiblissant, ou de favoriser des fuites du gaz spécial qui emplit souvent l'enveloppe.

L'invention repose sur l'emploi de capteurs à ondes acoustiques de surface (transpondeurs ou SAW). Il s'agit de capteurs sans fil comprenant un substrat à réflexion d'ondes et une antenne émettrice et réceptrice jointe à ce substrat et qui communique avec l'installation de mesure. Les ondes qu'elle reçoit sont transmises au substrat, modifiées en fonction de la valeur de la température sous forme d'un changement de fréquence ou de phase et lui reviennent. Les capteurs à ondes acoustiques de surface ont les avantages d'être simples, précis, dépourvus de matériel de transmission tels que des fils qui seraient impraticables ici, et de pouvoir être placés directement sur la portion du matériel à surveiller. Certains ont d'ailleurs été proposés dans l'art, par exemple dans US-A-5 739 419 (mais pour la mesure de pressions, ou la détection que le vide subsiste dans l'enveloppe du matériel) ou US-A-6111 548. Mais malgré leurs qualités, ils ne suffisent pas tels quels à donner une installation satisfaisante, à cause de la double nécessité d'utiliser un nombre de capteurs assez important pour suivre le fonctionnement de toute l'installation en mesurant la température à un nombre de points suffisant, et d'obtenir des mesures fiables. En l'absence de communication par fil ou par un moyen analogue, on est confronté à un encombrement de la bande passante disponible pour les communications. Et la plupart des capteurs à onde acoustique de surface n'ont pas une sensibilité suffisante pour mesurer une température avec une précision suffisante (de l'ordre de 2°C) ou risquent de dériver avec le temps ; or l'installation doit fonctionner pendant des dizaines d'années, de préférence sans être ouverte, ce qui exclut le remplacement des capteurs.

L'invention concerne donc un matériel électrique comprenant une partie active sous tension électrique et une enveloppe entourant la partie active, matériel électrique comprenant une partie active sous tension électrique et une enveloppe entourant la partie active, comprenant un capteur de température fixé sur la partie active, le capteur de température étant à ondes acoustiques de surface, sans fil et comprenant un substrat muni de réflecteurs d'ondes piézoélectriques s'y propageant et une antenne émettrice et réceptrice jointe au substrat, **caractérisé en ce que** le substrat est en tantalate de lithium et comportant deux résonateurs placés à des orientations à Y + 112° ($\pm$2°) et Y + 130°($\pm$2°) pour une coupe en X du substrat, les ondes piézoélectriques se propageant dans des direction analogues auxdites orientations; ou, sous une forme un peu différente pour laquelle les mêmes difficultés sont résolues par des moyens identiques, un matériel électrique comprenant une partie active sous tension électrique, une enveloppe entourant la partie active et un support isolant reliant la partie active à l'enveloppe, comprenant un capteur de température, le capteur étant à ondes acoustiques de surface, sans fil et comprenant un substrat muni de réflecteurs des ondes s'y propageant, et au moins une antenne émettrice et réceptrice jointe au substrat, **caractérisé en ce que** le capteur de température est fixé sur le support isolant reliant la partie active à l'enveloppe, le substrat est en tantalate de lithium et comporte deux résonateurs placés à des orientations à Y + 112°($\pm$2°) et Y + 130°($\pm$2°) pour une coupe en X du substrat, les ondes se propageant dans des directions analogues auxdits orientations. On verra comment ce capteur particulier améliore les caractéristiques de la mesure, à la fois quantitatives en permettant d'employer un grand nombre de capteurs à la fois, et quantitatives en améliorant la qualité des mesures. US-A-5 739 419 mentionne que le substrat du capteur peut être en tantalate de lithium, mais hors du contexte de mesure de températures, sans privilégier ce matériau et sans mentionner d'autres caractéristiques du capteur.

Le risque de décharges électriques partielles est supprimé si le capteur est logé dans la partie active ou le support de façon à ne pas en saillir.

Pouvoir placer un capteur directement sur la partie active qui est le siège de l'échauffement est évidemment très avantageux puisque les mesures sont plus précises et qu'elles concernent les parties réellement à surveiller du matériau. Une disposition préférentielle consiste à monter le capteur entre le conducteur primaire et l'isolateur, qui est pourvu d'un perçage central traversé par le conducteur primaire ; il est alors avantageux que l'antenne du capteur s'étende en direction angulaire du perçage central. Plus précisément, l'élément conducteur qui traverse le cône en position centrale est le plus souvent un porte-contacts qui supporte des deux côtés une extrémité d'une barre à haute tension (HT) : c'est donc contre lui que le capteur est placé.

Une difficulté réside dans l'impossibilité de démontage du matériel PSEM à seule fin de réparation du capteur. Le capteur doit donc être aussi durable que l'équipement primaire. Pour cela une conception robuste est nécessaire. Les capteurs envisagés ici sont d'un seul bloc, sans partie mobile ou exposée.

Il est aussi nécessaire que le capteur ne risque dans aucun cas de sortir de son logement en exploitation, car il pourrait rompre l'isolation entre les parties actives et l'enveloppe du matériau et provoquer un défaut majeur. Les mises en oeuvre préférées, décrites plus loin, ne présentent aucun risque de ce point de vue puisque le capteur est mécaniquement coincé entre le conducteur et l'isolateur.

Un point délicat de la mise en oeuvre du capteur reste la phase de montage. La conception longiligne et fine obtenue avec un substrat en position centrale par rapport à deux antennes permet la fabrication d'un capteur souple qui est courbé lors de la mise en place dans la gorge avant d'être recouvert par l'isolateur. Cette conception permet une autoadaptation à différents diamètres de barres.

Par ailleurs, la disposition du capteur autorise un usinage simplifié du conducteur central au moyen d'une simple gorge dont la profondeur de quelques millimètres (typiquement 2,5 mm) ne porte pas atteinte à la bonne conduction du courant primaire.

Les bords latéraux de la gorge usinée dans le porte-contacts pourraient être pourvus d'arrondis afin de préserver un champ électrique homogène dans la zone du capteur.

Une autre possibilité de montage possible est de créer une gorge dans l'isolateur plutôt que sur le porte-contacts.

Les barres ont un diamètre typiquement proche de 10 cm, ce qui conduit à une circonférence proche de 30 cm.

Une difficulté consiste à loger dans cette longueur l'antenne du capteur. Comme une antenne ordinaire est plus particulièrement efficace pour recevoir et émettre un signal radioélectrique à la longueur d'onde divisée par deux, cela conduit théoriquement à une longueur de 0,15 m à 1 GHz. Nous voyons ainsi que la circonférence de la gorge à cet emplacement est compatible avec des antennes fonctionnant autour de 1 GHz. Pour fonctionner, l'antenne n'est pas en contact direct du conducteur principal. Un isolant de faible épaisseur (environ 1 mm) recouvre l'antenne. Cet isolant, de matière Duroid (marque déposée) par exemple, peut supporter directement l'antenne, constituée d'une piste en surface. Le Duroid, permettant une production à faible coût, est caractérisé par la stabilité de ses propriétés à haute fréquence. Dans ce cas, l'antenne pourrait avoir une forme de type dipôle replié ou à fente.

L'utilisation d'une antenne conformée à cet endroit est donc un des aspects innovants, rendant possible la liaison avec le capteur lui-même ; l'utilisation d'une matière à faible constante diélectrique (par exemple Duroid 5880 Er 2.2) comme diélectrique entre conducteur primaire et antenne étant un autre de ces aspects.

Une autre façon de réaliser l'antenne consiste à utiliser le conducteur à haute tension comme plan de masse de l'antenne qui dans ce cas est de type planaire (patch).

L'invention va maintenant être décrite plus en détail dans ces aspects et d'autres au moyen des figures suivantes :

- la figure 1 représente une coupe longitudinale de l'invention,
- la figure 2 représente une vue agrandie de l'implantation du capteur et de ses parages,
- la figure 3 représente une coupe transversale illustrant une disposition intéressante du capteur,
- et la figure 4 est un agrandissement de la figure 2,
- et la figure 5 est un schéma du capteur utilisé.

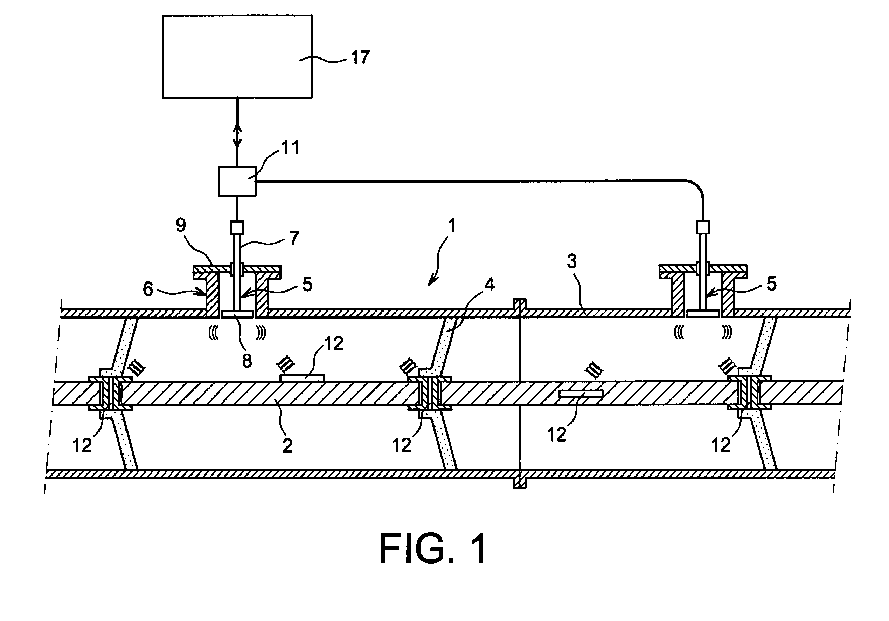

La figure 1 représente un câble 1 isolé à haute tension de structure coaxiale comprenant une barre 2 conductrice au centre et une enveloppe isolante 3 l'entourant, avec des isolateurs 5 en forme de cônes en résine époxy servant de supports à la barre 2 dans l'enveloppe 3. Le dispositif comprend encore une antenne de communication 5 établie à travers une traversée 6 de l'enveloppe 3, destinée à la détection de décharges partielles dans le câble 1. La forme de l'antenne de communication 5 est connue et peut comprendre, après une tige 7, une extrémité 8 en forme de disque à l'intérieur de l'enveloppe 3. La tige 7 s'étend dans le sens du câble 1 et elle est retenue dans le perçage d'un couvercle 9 fermant la traversée 6 et maintenant donc le confinement du câble 1, qui peut être empli d'un gaz isolant et notamment d'hexafluorure de soufre.

Un distributeur électrique 11 permet de relier chaque antenne de communication 5 à un appareil de mesure 17 par l'intermédiaire de fils hors du câble 1.

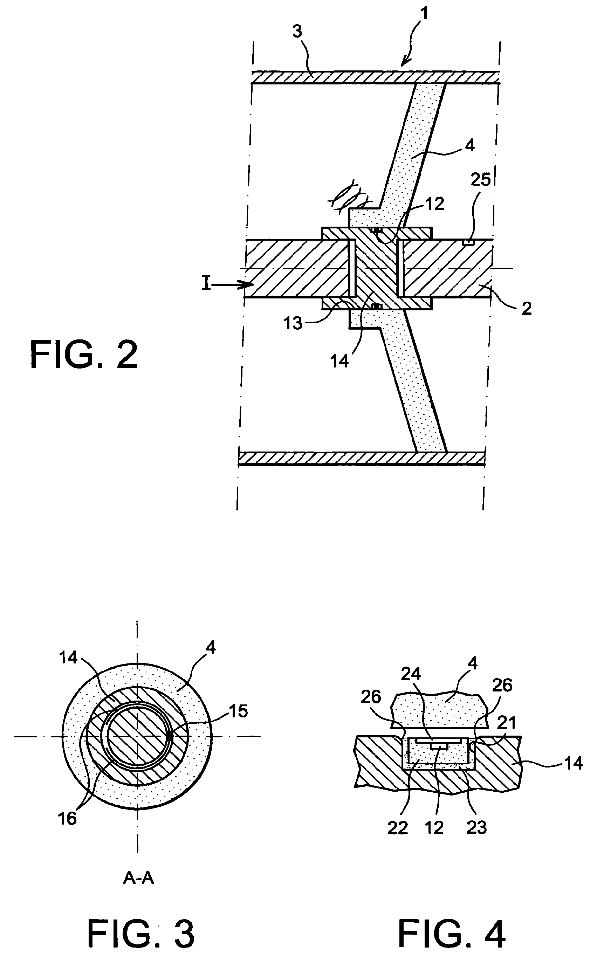

L'invention repose sur l'emploi de capteurs à ondes acoustiques de surface 12, appelés aussi capteurs SAW ou transpondeurs. Ils sont affectés ici à la mesure de la température du câble 1 et plus précisément de la barre 2, sur laquelle ils sont placés. Certains des capteurs 12 sont fixés sur la barre 2 entre deux supports isolants 4, alors que d'autres sont placés entre la barre 2 et un perçage central 13 des supports isolants 4 ou toute autre partie active, ainsi qu'on le représente bien aux figures 2 et 3 ; ces derniers capteurs 12 sont logés dans des gorges établies à la périphérie de portes-contacts 14 joignant des tronçons consécutifs de la barre 2, qui sont retenus dans les perçages 13. La figure 3 montre que les capteurs 12 comprennent un substrat 15, et au moins une antenne 16 jointe au substrat 15, beaucoup plus longue et s'étendant, dans la gorge du porte-contacts 14, dans la direction angulaire. Une seconde antenne peut être adjointe au substrat 15, chaque résonateur pouvant avoir sa propre antenne, ou l'émission et la réception peuvent être faites par des antennes différentes. La réalisation représentée notamment à la figure 3 comporte deux antennes 16 s'étendant dans deux directions opposées dans la gorge à partir du substrat 15, sur des portions de demi-cercles respectifs et opposés. Cette conception permet d'ajuster facilement la courbure du capteur 12 au diamètre du porte-contacts 14, ou de toute autre pièce autour de laquelle il est installé. Pour un substrat d'environ 1,8 mm d'épaisseur, de 3 mm de largeur et 6 mm de longueur environ, une gorge 21 (figure 4) de 2,5 mm de profondeur et 15 mm de largeur peut être pratiquée dans le porte-contacts 14. La gorge 21 perturbe la conduction de l'électricité, mais une profondeur pouvant aller jusqu'à 5 mm environ est admissible pour des équipements usuels. La gorge 21 peut être pourvue d'arrondis 26 à ses bords latéraux externes pour ne pas perturber à l'excès la forme du champ électrique. Un support diélectrique 22 comprenant une empreinte dans laquelle le capteur 12 est logé est collé par un joint 23 au fond de la gorge. Le support diélectrique 22 peut être en Duroid (marque déposée) ou un autre polymère souple. Le capteur 12 lui est intégré par fabrication et y adhère. Une flexion du support diélectrique 22 conforme l'antenne 16 automatiquement et sans difficulté à l'état de montage en la fléchissant elle aussi. La manipulation et le montage du capteur 22 sont alors aisés. Le support diélectrique 22 peut être ajusté aux dimensions de la gorge 21, par découpage ou tout autre moyen, et sa position de montage peut aussi être ajustée. Un couvercle 24 diélectrique protège le capteur 12. Une disposition analogue, avec une gorge (25 sur la figure 2) axiale ou angulaire, pourrait être prévue pour les capteurs 12 disposés sur la barre 2 ou un autre conducteur, afin qu'ils ne saillent pas à sa surface extérieure et ne contribuent pas à des décharges électriques partielles. Les dimensions des gorges ne sont par ailleurs pas critiques tant qu'elles n'affaiblissent pas trop la résistance ou la conductivité de leur support. Le capteur 12 a une souplesse suffisante pour qu'on puisse le monter dans de telles conditions. Comme il fonctionne à des fréquences élevées, ses antennes 16 sont courtes, et il est de petites dimensions, si bien qu'il est facile à monter à de nombreux exemplaires. En variante, la gorge 21 pourrait être creusée dans le support isolant 4, même si la détection pouvait devenir moins précise.

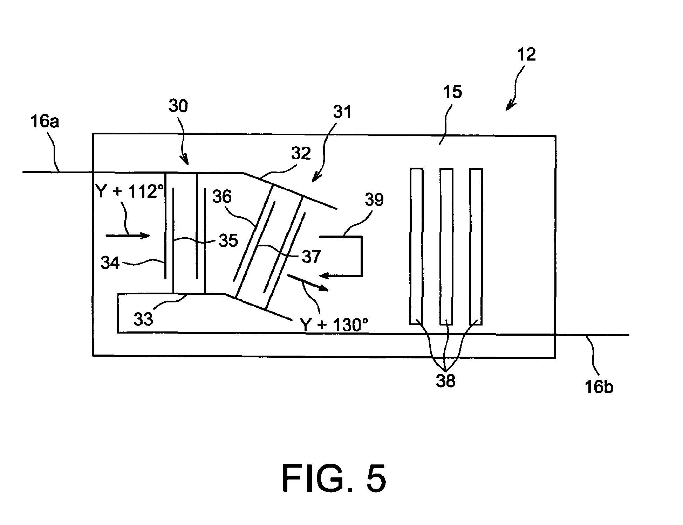

Les capteurs 12 à ondes acoustiques de surface travaillent en convertissant les ondes électromagnétiques en ondes acoustiques propagées dans le substrat 15 par piézoélectricité, et vice-versa. L'antenne 16 conduit l'onde incidente dans le substrat 15, à chacun des résonateurs, qui renvoient l'onde avec un décalage en fréquence variable en fonction de la température du capteur. Ils fonctionnent dans la bande passante du matériel électrique, pour laquelle les enveloppes 3 fonctionnent en guides d'ondes. Plus précisément, en se référant à la figure 5, leur substrat 15 porte des résonateurs 30 et 31, ici en nombre de deux conformément à l'invention, et qui sont reliés chacun aux antennes 16 d'entrée et de sortie. Ils comprennent une ligne de bus 32 commune prolongeant l'antenne d'entrée (16a) et une autre ligne de bus 33 commune prolongeant l'antenne de sortie (16b), et une ou plusieurs paires de lignes de transmissions (34 pour le résonateur 30 et 36 pour le résonateur 31) reliées à la ligne de bus 32 et de ligne de transmission (35 pour le résonateur 30 et 37 pour le résonateur 31) reliées à l'autre ligne de bus 33. Les lignes de transmissions de chaque paire se font face à peu de distance et l'ensemble a donc une allure en peignes imbriqués « interdigités »).

L'énergie électrique arrivant de l'antenne d'entrée 16a est absorbée par le substrat 15 après avoir atteint les lignes des transmissions 34 et 36 reliées à la ligne de bus 32 grâce à piézoélectricité du matériau circule sous formes d'ondes acoustiques de surface (ondes de Rayleigh), jusqu'à atteindre des réflecteurs 38 qui la renvoient vers les résonateurs 30 et 31, où elle est communiquée aux lignes de transmission 35 et 37 reliées à l'antenne de sortie 16b, et reconvertie en énergie électrique. Elle peut alors être captée par l'antenne de communication 5.

La direction de propagation de l'énergie dans le substrat 15, représentée par la flèche à demi-tour 39, dépend donc de l'orientation des réflecteurs 38, à laquelle elle est perpendiculaire. Les lignes de transmission 34 à 37 sont agencées sensiblement parallèles aux réflecteurs 38 pour recueillir au mieux l'énergie, ce qui revient à dire que les résonateurs 30 et 31 ont des orientations analogues à la direction de propagation 39 des ondes. Cette règle n'est toutefois pas respectée absolument dans l'invention, où l'un des résonateurs 30 est orienté dans la direction Y+112° (le substrat 15 étant à coupe en X) et l'autre dans la direction Y+130°. Les directions X et Y sont définies de façon conventionnelle en cristallographie, ici pour le substrat 15 en tantalate de lithium. D'autres modes de réalisations du capteur 12, conformes au fonctionnement et aux performances indiqués, sont possibles.

On va maintenant expliquer le motif du choix de deux résonateurs 30 et 31 pour un même capteur 12. Les caractéristiques géométriques du capteur 12 favorisent la transmission de l'énergie à une fréquence de résonance bien définie pour chacun des résonateurs 30 et 31. Or cette fréquence de résonance dépend des dilatations du substrat 15 et donc de sa température environnante après un étalonnage préliminaire. On dispose déjà, dans le cas de substrats en quartz qui sont les plus usuels pour fabriquer les capteurs à ondes acoustiques de surface, de graphiques donnant les coefficients de variation de la fréquence avec la température en fonction de l'orientation du résonateur sur le plan de coupe.

Les caractéristiques du substrat 15 sont toutefois susceptibles de s'altérer sous forme d'une variation uniforme de la fréquence de résonance quelle que soir les résonateurs. C'est pourquoi on décide de pratiquer ici une mesure différentielle, en calculant, au lieu de L$F(T)$-$F(T_0)$J, où F est la fréquence de résonance d'un résonateur, $T_0$ la température de référence et T la température pendant la mesure, à déduire de ce calcul, T {L$F_{30}(T)$-$F_{30}(T_0)$J-[$F_{31}(T)$-$F_{31}(T_0)$]} c'est-à-dire la différence de la quantité précédente pour chacun des résonateurs 30 et 31, pour annuler la dérive des propriétés du substrat 15. Un étalonnage préliminaire permettra de déduire T de la quantité { } mesurée, comme dans le cas classique à un résonateur.

Il est toutefois apparu que les substrats en quartz avaient des performances inférieures dans ce contexte, la différence de coefficients $\Delta CTF1$ de variations de la fréquence de résonance entre deux résonateurs étant d'environ $6.10^{-6}$ /°C pour des résonateurs placés à des orientations admissibles, c'est-à-dire d'orientations assez proches de la direction de propagation de l'énergie pour en recueillir une quantité suffisante à la mesure tout en faisant entre elles un angle suffisant (15 à 20° pour émettre des signaux différents. De plus, la variation de la fréquence de résonance dans le quartz obéit en réalité à une loi parabolique, ce qui signifie qu'elle s'écrit $F(T) = F(T_0) + CFT_1 (T-T_0) + CTF_2 (T-T_0)^2$, et la différence $\Delta CTF2$ entre coefficients CTF2 de deux résonateurs croît assez vite en fonction de l'angle de leurs orientations : alors que l'influence du terme CTF2 $(T-T_0)^2$ est généralement assez faible pour être négligée dans les applications les plus courantes avec un seul résonateur, l'influence du terme $\Delta CTF2(T-T_0)^2$ risque de ne plus l'être avec deux résonateurs placés à un angle de 15 à 20° environ dans la plage de température utile à la présente application.

Les mesures seraient alors susceptibles d'être trop imprécises puisque l'influence du vieillissement du substrat serait difficile à évaluer, et la plage de la variation totale $\Delta F(T)$ deviendrait trop large d'après les contraintes d'acceptation de la bande passante.

La tantalate de lithium a les avantages d'offrir une variation purement linéaire ou presque de F(T), c'est-à-dire que CTF2 ≈ 0, et que le coefficient Δ***CTF*1** de la variation ΔF(T) = ΔCTF1 (T-T$_0$) + ΔF(T-T$_0$) peut être sensiblement plus important que dans le cas du quartz. Des substrats en tantalate de lithium étant déjà utilisés comme filtres avec une coupe en X et une direction de propagation d'ondes de Y+112°, on a placé un premier résonateur dans cette direction Y+112° puis un second, et on a constaté un coefficient ΔCTIF1 très satisfaisant, égal à 10,10$^{-6}$ /°C pour le second résonateur à l'orientation Y+130°, ce qui permet de mesurer la variation différentielle des fréquences de résonance avec une précision suffisante sur toute la plage de températures envisagée.

Des résultats satisfaisants pourraient encore être obtenus avec es orientations un peu différentes des résonateurs, par exemple de ±2° pour chacun d'eux.

Il faut souligner que ce coefficient ΔCTF1 assez grand n'agrandit pourtant pas tellement la plage de mesure d'un capteur et ne nuit donc guère à une occupation dense de la bande passante. En effet, il faut respecter un écart de fréquences de résonance assez important entre les résonateurs d'un même capteur pour être sûr de les distinguer, quelles que soient les variations de fréquences de chacun d'eux.

L'écart de ces fréquences doit être d'au moins 5 MHz environ, quelle que soit la température. On pourra choisir un écart de fréquence de 7 MHz entre les résonateurs 30 et 31 de chaque capteur 12, et de 15 MHz entre les résonateurs respectifs de deux capteurs 12 successifs, pour le milieu de la plage de température (par exemple 75°C pour une plage de 0°C à 150°C). Une quarantaine de tels capteurs 12 pourra être installée dans l'appareillage d'après les considérations détaillées ci-dessous, ce qui est suffisant pour nombre d'applications. Les variations de fréquence de résonance seront de 2,7 MHz et 4,2 MHz respectivement pour les résonateurs 30 et 31. Les fréquences de résonance varieront donc dans une plage totale d'environ

$$[7 + \frac{(2,7+4,2)}{2}] = 10,95 \text{ MHz, lien inférieure}$$

aux 15 MHz d'écart entre deux capteurs 12, même en tenant compte d'imprécisions de fabrication qui altéraient ces valeurs nominales.

Des essais ont montré que les enveloppes métalliques des matériels blindés, d'un diamètre de 400 mm par exemple, se comportent comme des filtres passe-haut avec une fréquence de coupure à 440 MHz. Les antennes de communication 5 présentent ordinairement une bande passante comprise entre 100 MHz et 2 GHz. Dans ce cas de figure, il est donc possible d'utiliser la bande de 440 MHz à 2 GHz pour communiquer entre l'antenne de communication 5 et un ou plusieurs capteurs 12 à ondes acoustiques de surface par l'intermédiaire de l'enveloppe 3 servant de guide d'ondes. L'utilisation pour les capteurs 12 de substrats 15 en tantalate de lithium fonctionnant à une fréquence utilisable entre 900 MHz et 2 GHz environ est particulièrement adaptée pour bien occuper la bande passante, puisque usuellement on voudra disposer d'un grand nombre de points de mesure. Les ondes occupent tout le volume dans l'enveloppe 3 le long de quelques mètres ou quelques dizaines de mètres et peuvent ainsi desservir plusieurs capteurs 12 éloignés. Aucune communication par fil n'est donc nécessaire.

Un autre critère, encore plus important, à considérer est la sensibilité des capteurs 12, c'est-à-dire la surtension qu'ils possèdent.

La surtension d'un résonateur conditionne la précision de la mesure, ici celle de la température, puisque plus la surtension est forte plus le signal reçu décroît lentement. Une précision de ±2°C au moins étant nécessaire, on a constaté qu'une surtension d'au moins 6000 serait nécessaire avec un substrat en quartz ; or les valeurs obtenues étaient au mieux analogues, et on attendait des valeurs de 5000 dans des conditions ordinaires de fabrication, ce qui signifie que les substrats en quartz étaient probablement inaptes à l'application envisagée.

Les substrats en tantalate de lithium possédaient au contraire une surtension de 17000 environ, pour une valeur requise de 5000 seulement environ (avec les lignes 32 à 37 de 70 nm d'épaisseur environ en aluminium). Cet avantage inattendu fut décisif pour le choix du tantalate de lithium pour le substrat 15.

## Revendications

**1.** Matériel électrique comprenant une partie active (2) sous tension électrique et une enveloppe (3) entourant la partie active (2), comprenant un capteur (12) de température, le capteur (12) de température étant à ondes acoustiques de surface, sans fil et comprenant un substrat (15) muni de réflecteurs (38) des ondes s'y propageant et au moins une antenne (16) émettrice et réceptrice jointe au substrat, **caractérisé en ce que** le substrat est en tantalate de lithium et comporte deux résonateurs placés à des orientations à Y + 112° (±2°) et Y + 130°(±2°) pour une coupe en X du substrat, les ondes se propageant dans des directions analogues auxdits orientations, le capteur de température (12) étant fixé soit sur la partie active (2) soit sur un support isolant (4) reliant la partie active (2) à l'enveloppe (3) .

**2.** Matériel électrique selon la revendication 1, **caractérisé en ce que** la partie active est une barre conductrice et l'enveloppe est cylindrique.

**3.** Matériel électrique selon les revendications 1 et 2, **caractérisé en ce que** le capteur de température est disposé en étant retenu entre la barre conductrice et le support, le support (4) étant pourvu d'un perçage central traversé par la barre.

**4.** Matériel électrique selon la revendication 3, **caractérisé en ce que** l'antenne du capteur de température s'étend en direction angulaire du perçage central.

**5.** Matériel électrique selon la revendication 4, **caractérisé en ce qu'**il comprend une seconde antenne, le substrat étant en position centrale par rapport aux antennes, qui s'étendent sur deux portions opposées de demi-cercles.

**6.** Matériel électrique selon la revendication 1 ou 2, **caractérisé en ce que** le capteur de température est logé dans une gorge creusée dans la partie active.

**7.** Matériel électrique selon la revendication 6, **caractérisé en ce que** la gorge a au plus 5 mm de profondeur.

**8.** Matériel électrique selon la revendication 1, **caractérisé en ce que** le capteur de température est intégré à un support diélectrique (22) souple.

**9.** Matériel électrique selon les revendications 6 et 8, **caractérisé en ce que** le support diélectrique (22) souple est ajusté et collé dans la gorge.


**Claims**

**1.** Electrical apparatus including a live part (2) to which a voltage is applied, and a casing (3) surrounding the live part (2), including a temperature sensor (12), the temperature sensor (12) being a wireless surface acoustic wave sensor having a substrate provided with reflectors (38) of the sound waves propagating therein and at least an emitting and receiving antenna (16) connected to the substrate, **characterized in that** the substrate is of lithium tantalate and comprises two resonators positioned at orientations of Y + 112° ($\pm 2°$) and Y + 130° ($\pm 2°$) for a X section of the substrate, the waves propagating in direction similar to said orientations, the temperature sensor (12) being fixed either on the live part (2) or an insulating support (4) connecting the live part (2) to the envelope (3).

**2.** Electrical apparatus according to claim 1, **characterized in that** the live part is a bar conductor and the casing is cylindrical.

**3.** Electrical apparatus according to claims 1 and 2, **characterized in that** the sensor is positioned by being held between the bar conductor and the support, the support (4) having a central hole through which the bar conductor extends.

**4.** Electrical apparatus according to claim 3, **characterized in that** the antenna of the sensor extends in a circumferential direction of the said central hole.

**5.** Electrical apparatus according to claim 4, **characterized in that** it further includes a second antenna, the substrate being in a central position relative to the antennae, and the antennae entered on two opposed semicircular portions.

**6.** Electrical apparatus according to claim 1 or claim 2, **characterized in that** the temperature sensor is fitted in a groove formed in the live part.

**7.** Electrical apparatus according to claim 6, **characterized in that** the groove has a depth of 5 mm at most.

**8.** Electrical apparatus according to claim 1, **characterized in that** the temperature sensor is incorporated in a flexible dielectric support (22).

**9.** Electrical apparatus according to claims 6 and 8, **characterized in that** the flexible dielectric support (22) is matched to, and adhesively bonded in, the groove.


**Patentansprüche**

**1.** Elektrische Einrichtung, enthaltend einen aktiven Teil (2) unter elektrischer Spannung und einen Mantel (3), der den aktiven Teil (2) umgibt, sowie einen Temperaturmessftihler (12), wobei der Temperaturmessfühler (12) als drahtloser Sensor für akustische Oberflächenwellen ausgebildet ist, der ein Substrat (15) aufweist, das mit Reflektoren (38) für die sich darin ausbreitenden Wellen ausgestattet ist, und zumindest eine mit dem Substrat verbundene Sende- und Empfangsantenne (16) umfasst, **dadurch gekennzeichnet, dass** das Substrat ein Lithium-Tantalat ist und zwei Resonatoren aufweist, die bei einem X-Schnitt des Substrats mit den Ausrichtungen Y + 112° ($\pm$ 2°) und Y + 130° ($\pm$ 2°) angeordnet sind, wobei die Wellen sich in zu den Ausrichtungen analogen Richtungen ausbreiten, wobei der Temperaturmessfühler (12) entweder an den aktiven Teil (2) oder an einen Isolierhalter (4) befestigt ist, welcher den aktiven Teil (2) mit dem Mantel (3) verbindet.

**2.** Elektrische Einrichtung nach Anspruch 1, **dadurch gekennzeichnet, dass** der aktive Teil eine Sammelstromschiene ist und der Mantel zylindrisch ist.

**3.** Elektrische Einrichtung nach den Ansprüche 1 und 2, **dadurch gekennzeichnet, dass** der Temperaturmessfühler zwischen der Sammelstromschiene und dem Halter angeordnet ist und dabei festgehalten wird, wobei der Halter (4) mit einer zentralen Bohrung versehen ist, durch weich sich die Schiene erstreckt.

4. Elektrische Einrichtung nach Anspruch 3, **dadurch gekennzeichnet, dass** die Antenne des Temperaturmessfühlers sich in Wickelrichtung der zentralen Bohrung erstreckt.

5. Elektrische Einrichtung nach Anspruch 4, **dadurch gekennzeichnet, dass** sie eine zweite Antenne aufweist, wobei das Substrat in mittiger Stellung bezüglich der Antennen liegt, die sich über zwei entgegengesetzte Halbkreisabschnitte erstrecken.

6. Elektrische Einrichtung nach Anspruch 1 oder 2, **dadurch gekennzeichnet, dass** der Temperaturmessfühler in einer in den aktiven Teil eingebrachten Nut aufgenommen ist.

7. Elektrische Einrichtung nach Anspruch 6, dadurch gekennzeichet, dass die Nut höchstens 5 mm tief ist.

8. Elektrische Einrichtung nach Anspruch 1, **dadurch gekennzeichnet, dass** der Temperaturmessfühler einem nachgiebigen dielektrischen Halter (22) eingegliedert ist.

9. Elektrische Einrichtung nach den Ansprüchen 6 und 8, **dadurch gekennzeichnet, dass** der nachgiebige dielektrische Halter (22) in die Nut eingepasst und darin verklebt ist.

FIG. 1

**FIG. 2**

**FIG. 3**

A-A

**FIG. 4**

FIG. 5

**EP 2 283 553 B1**

**Documents brevets cités dans la description**

- US 5739419 A

- US 6111548 A